# EUROPEAN PATENT APPLICATION

(11) **EP 4 761 123 A1**
(43) Date of publication of application: **17.06.2026**
(21) Application number: 24874838.6
(22) Date of filing: 24.07.2024
(51) Int. Cl.: H04B 1/50, H04B 1/00, H04W 52/54, H04B 1/40, H04B 1/04

(54) **FRONT-END CIRCUITRY INCLUDING POWER AMPLIFIER CONNECTED TO OTHER FRONT-END CIRCUITRY, AND ELECTRONIC DEVICE COMPRISING SAME**

(30) Priority: 06.10.2023 KR 20230133543; 07.11.2023 KR 20230152647
(71) Applicant: Samsung Electronics Co., Ltd., Suwon-si, Gyeonggi-do 16677 (KR)
(72) Inventor: MOON, Yohan, Suwon-si Gyeonggi-do 16677 (KR); NA, Hyoseok, Suwon-si Gyeonggi-do 16677 (KR); YANG, Dongil, Suwon-si Gyeonggi-do 16677 (KR)
(74) Representative: HGF
(86) International application number: PCT/KR2024/010687
(87) International publication number: WO 2025/075279

(57) **Abstract**

An electronic device is provided. The electronic device may comprise a first antenna. The electronic device may comprise a second antenna. The electronic device may comprise first front-end circuitry including a low noise amplifier (LNA) configured to be connected to the first antenna to amplify a first signal on a downlink frequency range of a first frequency band received through the first antenna. The electronic device may comprise second front-end circuitry including: a first power amplifier (PA) configured to be connected to the first antenna via the first front-end circuitry to obtain transmission power of a second signal on an uplink frequency range of the first frequency band transmitted via the first antenna; and a second PA configured to be connected to the second antenna to obtain transmission power of a third signal on an uplink frequency range of the second frequency band transmitted via the second antenna.

## Description

### [Technical Field]

The disclosure relates to front end circuitry including a power amplifier (PA) connected to another front end circuitry and an electronic device including the same.

### [Background Art]

An electronic device may include front end circuitry to transmit and/or receive a signal on each of various frequencies. For example, the front end circuitry may include a power amplifier (PA) for transmit (Tx) power of a signal to be transmitted from the electronic device through antennas connected to the front end circuitry.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. The electronic device may comprise a first antenna. The electronic device may comprise a second antenna. The electronic device may comprise first front end circuitry including a low noise amplifier (LNA) configured to be connected to the first antenna to amplify a first signal on a downlink frequency range of a first frequency band that is received through the first antenna. The electronic device may comprise second front end circuitry that includes a first power amplifier (PA) configured to be connected to the first antenna through the first front end circuitry to obtain transmit (Tx) power of a second signal on an uplink frequency range of the first frequency band that is transmitted through the first antenna, and a second PA configured to be connected to the second antenna to obtain a Tx power of a third signal on an uplink frequency range of a second frequency band that is transmitted through the second antenna. The first front end circuitry may be configured to transmit the second signal with Tx power obtained using the first PA in the second front end circuitry configured to be connected to the first antenna.

An electronic device is provided. The electronic device may comprise a first antenna. The electronic device may comprise a second antenna. The electronic device may comprise a third antenna. The electronic device may comprise first front end circuitry including a terminal connected to the first antenna from among the first antenna, the second antenna, and the third antenna. The electronic device may comprise second front end circuitry including a terminal connected to the second antenna from among the first antenna, the second antenna, and the third antenna, the second front end circuitry. The second front end circuitry may further include a first power amplifier (PA) that is configured to be connected to the first antenna through the first front end circuitry and is disconnected from the second antenna, and a second PA configured to be connected to the second antenna. The electronic device may comprise include a terminal connected to the third antenna from among the first antenna, the second antenna, and the third antenna. The third front end circuitry may further include a PA configured to be connected to the third antenna. The electronic device may comprise a; at least one processor, comprising processing circuitry. The at least one processor is individually and/or collectively configured to control the first PA in the second front end circuitry to obtain transmit (Tx) power of a second signal on a second uplink frequency range of a first frequency band that is transmitted, while a first signal on a first uplink frequency range of the first frequency band is transmitted with Tx power obtained using the PA in the third front end circuitry through the third antenna, through the first antenna. The at least one processor may be individually and/or collectively configured to control the second PA in the second front end circuitry to obtain Tx power of a third signal on an uplink frequency range of a second frequency band transmitted, while the first signal is transmitted with Tx power obtained using the PA in the third front end circuitry through the third antenna, through the second antenna.

An electronic device is provided. The electronic device may comprise a first antenna. The electronic device may comprise a second antenna. The electronic device may comprise a third antenna. The electronic device may comprise first front end circuitry including a terminal connected to the first antenna. The electronic device may comprise second front end circuitry including terminals respectively connected to the second antenna and the third antenna. The electronic device may comprise at least one processor comprising processing circuitry. The second front end circuitry may further include a first power amplifier (PA) configured to obtain Tx power of a first signal on an uplink frequency range of a first frequency band, a second PA configured to obtain Tx power of a second signal on an uplink frequency range of a second frequency band, and a switch configured to connect the first PA to an antenna from among the first antenna and the second antenna. The at least one processor, individually and/or collectively, may be configured to, while the second signal is transmitted with Tx power obtained using the second PA in the second front end circuitry through the third antenna, control the switch to connect the first PA in the second front end circuitry to the first antenna from among the first antenna and the second antenna to transmit the first signal with Tx power obtained using the first PA in the second front end circuitry through the first antenna from among the first antenna and the second antenna. The at least one processor, individually and/or collectively, may be configured to, while the second signal is transmitted with Tx power obtained using the second PA in the second front end circuitry through the third antenna, control the switch to connect the first PA in the second front end circuitry to the second antenna from among the first antenna and the second antenna to transmit the first signal with Tx power obtained using the first PA in the second front end circuitry through the second antenna from among the first antenna and the second antenna.

### [Description of the Drawings]

FIG. 1 illustrates an example of a portable device including a plurality of front end circuitry.
FIG. 2 illustrates an example of an electronic device that includes first front end circuitry and second front end circuitry including a power amplifier (PA) connected to the first front end circuitry.
FIG. 3 illustrates an example of an electronic device that includes first front end circuitry, second front end circuitry including a PA connected to the first front end circuitry, and third front end circuitry.
FIG. 4 illustrates an example of an electronic device that includes first front end circuitry and second front end circuitry including a PA connectable to the first front end circuitry.
FIG. 5 illustrates an example of an electronic device that includes first front end circuitry, second front end circuitry including a PA connectable to the first front end circuitry, and third front end circuitry.
FIG. 6 illustrates an example of another switch that replaces the switch in FIG. 5.
FIG. 7 is a block diagram of an electronic device in a network environment according to various embodiments.

### [Mode for Invention]

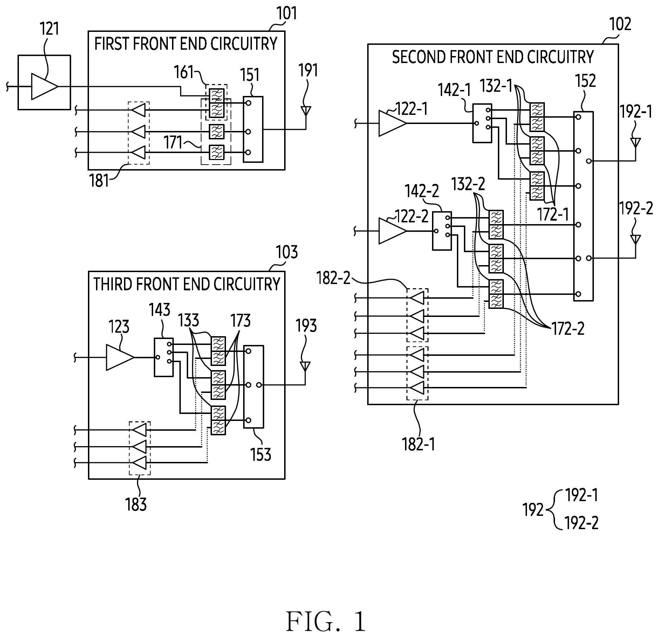

A portable device (or user equipment) in a wireless environment may support dual connectivity, which is connected with a network at several cells. The portable device may support various frequency bands for the dual connectivity to provide a robust wireless environment. For example, the portable device may include a plurality of front end circuitry (or front end circuit), in order to support the various frequency bands. A portable device including a plurality of front end circuitry is illustrated and described in greater detail below with reference to FIG. 1.

FIG. 1 illustrates an example of a portable device including a plurality of front end circuitry.

Referring to FIG. 1, a portable device, such as a smartphone, a tablet, a laptop, a smartwatch, and the like, may include a plurality of front end circuitry including first front end circuitry 101, second front end circuitry 102, and third front end circuitry 103. The portable device may include circuitry including a power amplifier (PA) 121.

The first front end circuitry 101 may, for example, be used for a signal on a downlink frequency range of a first frequency band that is received through an antenna 191. For example, the first front end circuitry 101 may include a terminal connected to the antenna 191. For example, the first front end circuitry 101 may include one or more low noise amplifiers (LNAs) 181 configured to amplify the signal on the downlink frequency range of the first frequency band. For example, the first front end circuitry 101 may include one or more filters 171 configured to pass the signal on the downlink frequency range of the first frequency band. As a non-limiting example, a portion of the one or more filters 171 may be included in a duplexer 161, as illustrated in FIG. 1. For example, the first front end circuitry 101 may include a switch 151 for selecting a reception path (or filter) to be connected to the antenna 191.

The second front end circuitry 102 may, for example, be used for a signal on a downlink frequency range of a second frequency band received through an antenna 192-1. For example, the second front end circuitry 102 may include a terminal connected to the antenna 192-1. For example, the second front end circuitry 102 may include one or more LNAs 182-1 configured to amplify the signal on the downlink frequency range of the second frequency band. For example, the second front end circuitry 102 may include one or more filters 172-1 configured to pass the signal on the downlink frequency range of the second frequency band. For example, the second front end circuitry 102 may include a switch 152 for selecting a reception path (or filter) to be connected to the antenna 192-1.

The second front end circuitry 102 may, for example, be used for a signal on a downlink frequency range of a third frequency band received through an antenna 192-2. For example, the second front end circuitry 102 may include a terminal connected to the antenna 192-2. For example, the second front end circuitry 102 may include one or more LNAs 182-2 configured to amplify the signal on the downlink frequency range of the third frequency band. For example, the second front end circuitry 102 may include one or more filters 172-2 configured to pass the signal on the downlink frequency range of the third frequency band. For example, the switch 152 may be further used to select a reception path to be connected to the antenna 192-2.

The second front end circuitry 102 may, for example, be used for a signal on an uplink frequency range of the second frequency band transmitted through the antenna 192-1. For example, the second front end circuitry 102 may include a power amplifier (PA) 122-1 configured to obtain Tx power of the signal on the uplink frequency range of the second frequency band to be transmitted through the antenna 192-1. For example, the second front end circuitry 102 may include one or more filters 132-1 for the signal on the uplink frequency range of the second frequency band to be transmitted through the antenna 192-1. A pair of at least a portion of the one or more filters 132-1 and at least a portion of the one or more filters 172-1 may be implemented as a duplexer. For example, the second front end circuitry 102 may include a switch 142-1 for selecting a transmission path (or filter) for the signal on the uplink frequency range of the second frequency band to be transmitted through the antenna 192-1. For example, the switch 152 may be further used to connect the antenna 192-1 to the transmission path selected through the switch 142-1.

The second front end circuitry 102 may, for example, be used for a signal on an uplink frequency range of the third frequency band transmitted through the antenna 192-2. For example, the third front end circuitry 102 may include a power amplifier (PA) 122-2 configured to obtain Tx power of the signal on the uplink frequency range of the third frequency band to be transmitted through the antenna 192-2. For example, the second front end circuitry 102 may include one or more filters 132-2 for the signal on the uplink frequency range of the third frequency band to be transmitted through the antenna 192-2. A pair of at least a portion of the one or more filters 132-2 and at least a portion of the one or more filters 172-2 may be implemented as a duplexer. For example, the second front end circuitry 102 may include a switch 142-2 for selecting a transmission path (or filter) for the signal on the uplink frequency range of the third frequency band to be transmitted through the antenna 192-2. For example, the switch 152 may be further used to connect the antenna 192-2 to the transmission path selected through the switch 142-2.

The third front end circuitry 103 may, for example, be used for a signal on another downlink frequency range of the first frequency band received through an antenna 193. The other downlink frequency range of the first frequency band supported by the third front end circuitry 103 may be the same as the downlink frequency range of the first frequency band supported by the first front end circuitry 101, or may be at least partially different from the downlink frequency range of the first frequency band supported by the first front end circuitry 101. For example, the term "another (or other)" of the other downlink frequency range of the first frequency band is merely used to distinguish between the downlink frequency range of the first frequency band supported by the first front end circuitry 101 and the downlink frequency range of the first frequency band supported by the third front end circuitry 103 within this disclosure. For example, the term "another" of the other downlink frequency range of the first frequency band does not indicate a downlink frequency range of the first frequency band that does not overlap the downlink frequency range of the first frequency band supported by the first front end circuitry 101. For example, the third front end circuitry 103 may include a terminal connected to the antenna 193. For example, the third front end circuitry 103 may include one or more LNAs 183 configured to amplify the signal on the other downlink frequency range of the third frequency band. For example, the third front end circuitry 103 may include one or more filters 173 configured to pass the signal on the other downlink frequency range of the first frequency band. For example, the third front end circuitry 103 may include a switch 153 for selecting a reception path connected to the antenna 193.

The third front end circuitry 103 may, for example, be further used for a signal on an uplink frequency range of the first frequency band transmitted through the antenna 193. For example, the third front end circuitry 103 may include a PA 123 configured to obtain Tx power of the signal on the uplink frequency range of the first frequency band to be transmitted through the antenna 193. For example, the third front end circuitry 103 may include one or more filters 133 for the signal on the uplink frequency range of the first frequency band to be transmitted through the antenna 193. A pair of at least a portion of the one or more filters 133 and at least a portion of the one or more filters 173 may be implemented as a duplexer. For example, the third front end circuitry 103 may include a switch 143 to select a transmission path (or filter) for the signal on the uplink frequency range of the first frequency band to be transmitted through the antenna 193. For example, the switch 153 may be further used to connect the antenna 193 to the transmission path selected through the switch 143.

For example, the portable device may further include a PA 121 configured to obtain Tx power of a signal on another uplink frequency range of the first frequency band. For example, the other uplink frequency range of the first frequency band may be the same as the uplink frequency range of the first frequency band supported by the third front end circuitry 103, or may be at least partially different from the uplink frequency range of the first frequency band supported by the third front end circuitry 103, or may be included within the uplink frequency range of the first frequency band supported by the third front end circuitry 103. For example, the term "another" of the other uplink frequency range of the first frequency band is merely used to distinguish between the uplink frequency range of the first frequency band supported by the third front end circuitry 103 and an uplink frequency range of the first frequency band of a signal transmitted through the PA 121 within this disclosure. For example, the term "another" of the other uplink frequency range of the first frequency band does not indicate the uplink frequency range of the first frequency band that does not overlap the uplink frequency range of the first frequency band supported by the third front end circuitry 103. For example, the PA 121 may be connected to the first front end circuitry 101, in order to transmit the signal on the other uplink frequency range of the first frequency band through the antenna 191. For example, the signal on the other uplink frequency range of the first frequency band may use the first front end circuitry 101 as a transmission path. For example, the first front end circuitry 101 may be connected to the PA 121 located outside the first front end circuitry 101, unlike the second front end circuitry 102 and the third front end circuitry 103. For example, the signal on the other uplink frequency range of the first frequency band may be transmitted with Tx power obtained using the PA 121 located outside the first front end circuitry 101 through the antenna 191 connected to the first front end circuitry 101. For example, the signal on the other uplink frequency range of the first frequency band may be transmitted through antenna 191, while the signal on the uplink frequency range of the first frequency band is transmitted through the antenna 193. For example, the signal on the uplink frequency range of the first frequency band and the signal on the other uplink frequency range of the first frequency band may be transmitted according to dual connectivity.

As a non-limiting example, the arrangement of the first front end circuitry 101, the second front end circuitry 102, the third front end circuitry 103, and the PA 121 as illustrated in FIG. 1 may be suitable to support dual connectivity. However, in order to include additional components for a higher quality service and/or a new service, changing the arrangement may be considered (or required).

For example, as an alternative to the illustration in FIG. 1, new front end circuitry integrating the first front end circuitry 101 and the PA 121 may be considered. However, since the new front end circuitry requires not only integrating the first front end circuitry 101 with the PA 121 but also including an additional transmission controller (or transmission control circuit) and including an additional die (or semiconductor die) for the PA 121, the new front end circuitry may not be suitable (or not recommended) in terms of a mounting space and/or cost.

As another example, as an alternative to the illustration of FIG. 1, new front end circuitry integrating the second front end circuitry 102 and the third front end circuitry 103 may be considered. However, the new front end circuitry may require internal isolation to support dual connectivity through a combination of the first frequency band and the second frequency band (or the third frequency band) alone. In addition, a temperature that rises while supporting dual connectivity through the combination of the first frequency band and the second frequency band (or the third frequency band) using the new front end circuitry alone may be higher (or much higher) than a temperature that rises while supporting dual connectivity through the combination of the first frequency band and the second frequency band (or the third frequency band) using the second front end circuitry 102 and the third front end circuitry 103 of FIG. 1. In addition, a size of the new front end circuitry, which is lager (or much larger) than a size of each of the second front end circuitry 102 and the third front end circuitry 103, may be a negative factor in terms of flexibility of the arrangement. Furthermore, since the new front end circuitry is integrated circuitry supporting the first frequency band, the second frequency band, and the third frequency band, a yield rate of the new front end circuitry may be less (or much less) than a yield rate of the first front end circuitry 101, a yield rate of the second front end circuitry 102, and a yield rate of the third front end circuitry 103.

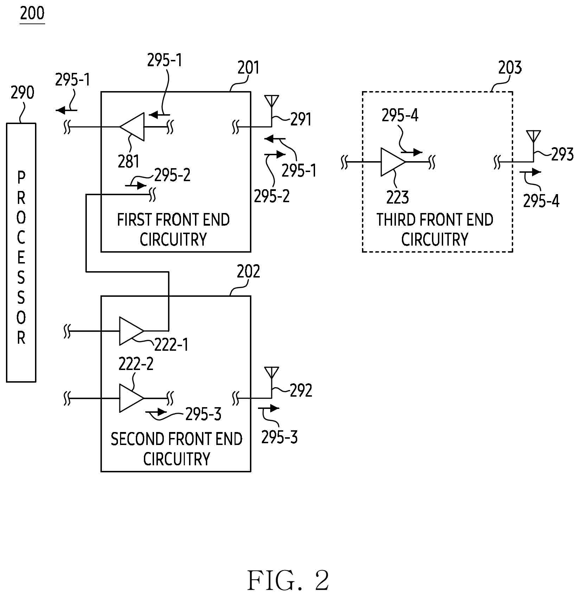

An electronic device (e.g., portable device) illustrated and described with reference to FIGS. 2 to 5 may include a PA (e.g., corresponding to the PA 121) connected to first front end circuitry (e.g., corresponding to the first front end circuitry 101) within second front end circuitry (e.g., corresponding to the second front end circuitry 102). The electronic device illustrated and described with reference to FIGS. 2 to 5 may provide a wider mounting space by including the PA connected to the first front end circuitry within the second front end circuitry.

FIG. 2 illustrates an example of an electronic device that includes first front end circuitry and second front end circuitry including a power amplifier (PA) connected to the first front end circuitry.

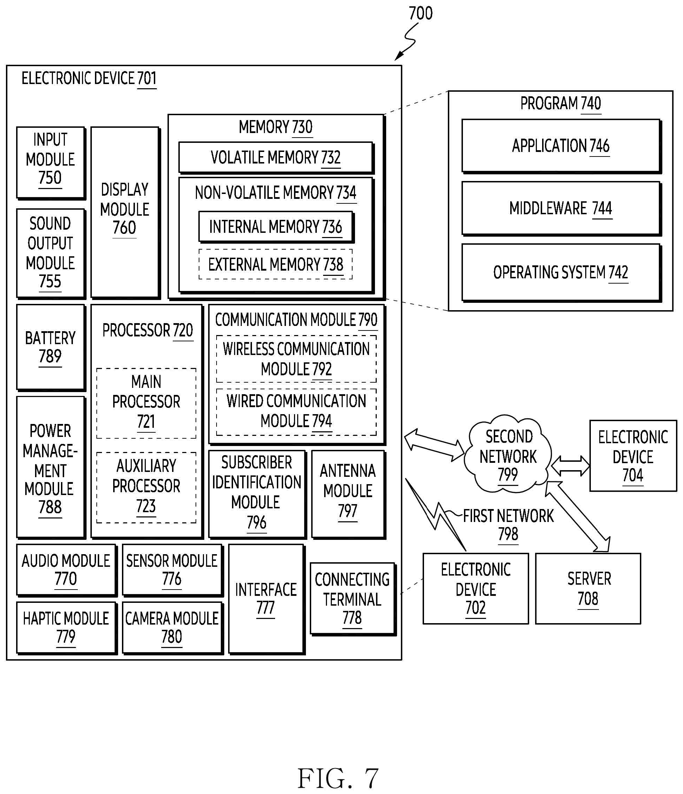

Referring to FIG. 2, an electronic device 200 may be a portable device, such as a smartphone, a tablet, a laptop, a smart watch, and the like. However, it is not limited thereto. For example, the electronic device 200 may also be a fixed device (or immobile device, or immovable device) such as a refrigerator, a television (TV), an Internet of things (IoT) hub device, and the like. The electronic device 200 may correspond to at least a portion of an electronic device 701 illustrated and described in greater detail below with reference to FIG. 7.

The electronic device 200 may include first front end circuitry 201, second front end circuitry 202, and a processor (e.g., including processing circuitry) 290.

The first front end circuitry 201 (or a first front end module (FEM) 201) may be used for a first signal 295-1 on a downlink frequency range of a first frequency band (e.g., a frequency band less than 1 gigahertz (GHz)) received through an antenna 291. For example, the first front end circuitry 201 may include a terminal connected to the antenna 291. For example, the first front end circuitry 201 may include an LNA 281 configured to amplify the first signal 295-1 received through the antenna 291. For example, the LNA 281 may be configured to be connected to the antenna 291 to amplify the first signal 295-1 received through the antenna 291. For example, the LNA 281 being connected to the antenna 291 may indicate the LNA 281 not only being connected directly to the antenna 291, but also the LNA 281 being connected to the antenna 291 through one or more components. For example, although not illustrated in FIG. 2, the first front end circuitry 201 may further include one or more components, such as a filter (or duplexer) and/or a switch, on (or within) a reception path from the antenna 291 to the LNA 281. For example, the first signal 295-1 amplified by the LNA 281 may be provided to the processor 290 through radio frequency integrated circuitry (or radio frequency integrated circuit (RFIC)) (not illustrated).

As a non-limiting example, although the first front end circuitry 201 has a transmission path (not illustrated in FIG. 2, but may include a filter (or duplexer) and/or a switch) for a signal (e.g., a second signal 295-2) from a PA 222-1 within the second front end circuitry 202 to be illustrated below, the first front end circuitry 201 may not include a PA for transmitting a signal unlike the second front end circuitry 202 (and/or the third front end circuitry 203). For example, the first front end circuitry 201 may not include any PA configured to obtain Tx power of a signal, unlike the second front end circuitry 202 (and/or the third front end circuitry 203).

The second front end circuitry 202 (or a second FEM 202) may be used to transmit a second signal 295-2 on an uplink frequency range of the first frequency band through the antenna 291. For example, the second front end circuitry 202 may include a terminal (indirectly) connected to the antenna 291 through the first front end circuitry 201. For example, the second front end circuitry 202 may include the PA 222-1 configured to obtain Tx power of the second signal 295-2 to be transmitted through the antenna 291. For example, the PA 222-1 may be configured to be connected to the antenna 291 from among the antenna 291 and an antenna 292. For example, the PA 222-1 may be configured to be connected to the antenna 291 through the first front end circuitry 201. For example, the PA 222-1 may be disconnected from the antenna 292. For example, an output terminal of the PA 222-1 may be connected to a terminal (or input terminal) of the first front end circuitry 201. For example, the PA 222-1 may be used to transmit a signal (e.g., the second signal 295-2) through another front end circuitry (e.g., the first front end circuitry 201) distinguished from front end circuitry (e.g., the second front end circuitry 222-1) including the PA 222-1, unlike a PA 222-2 to be illustrated below. As a non-limiting example, the PA 222-1 may be used to transmit a signal (e.g., the second signals 295-2) on the uplink frequency range of the first frequency band not supported by one or more filters (and/or one or more duplexers) within the second front end circuitry 202, unlike a PA 222-2 for transmission of a signal (e.g., a third signal 295-3) on the uplink frequency range of the second frequency band supported by one or more filters (and/or one or more duplexers) within the second front end circuitry 202. For example, the first front end circuitry 201 may be configured to transmit the second signal 295-2 with Tx power obtained using the PA 222-1 within the second front end circuitry 202, which is configured to be connected to the antenna 291.

The second front end circuitry 202 (or the second FEM 202) may be further used to transmit a third signal 295-3 on the uplink frequency range of the second frequency band (e.g., a frequency band greater than 1 GHz) through the antenna 292. For example, the second front end circuitry 202 may include a terminal (directly) connected to the antenna 292. For example, the second front end circuitry 202 may include a PA 222-2 configured to obtain Tx power of the third signal 295-3 to be transmitted through the antenna 292. For example, the PA 222-2 may be configured to be connected to the antenna 292 to obtain the Tx power of the third signal 295-3 to be transmitted through the antenna 292. For example, the PA 222-2 being connected to the antenna 292 may indicate the PA 222-2 not only being connected directly to the antenna 292, but also the PA 222-2 being connected to the antenna 292 through one or more components. For example, although not illustrated in FIG. 2, the second front end circuitry 202 may further include one or more components, such as a filter (or duplexer) and/or a switch, on (or within) a transmission path from the PA 222-2 to the antenna 292. For example, the PA 222-2 may be disconnected from the antenna 291. For example, the second front end circuitry 202 may be configured to transmit the third signal 295-3 through the antenna 292. For example, the second front end circuitry 202 may be configured to provide the first front end circuitry 201 with the second signal 295-2 to be transmitted through the antenna 291. For example, the second front end circuitry 202 may be configured to transmit the third signal 295-3, while the second signal 295-2 is transmitted through the antenna 291, through the antenna 292. For example, the second front end circuitry 202 may be configured to transmit the third signal 295-3, while the first signal 295-1 is received through the antenna 291, through the antenna 292.

As a non-limiting example, as described above, the second front end circuitry 202 may include the PA 222-1 corresponding to the PA 121 of FIG. 1 and the PA 222-2 corresponding to the PA 122-1 (and/or the PA 122-2 of FIG. 1). For example, the second front end circuitry 202 may correspond to front end circuitry integrating the PA 121 of FIG. 1 and the second front end circuitry 102 of FIG. 1. For example, integrating the second front end circuitry 102 with the PA 121 like the second front end circuitry 202 may be more efficient than alternatives illustrated above (alternatives described in the description of FIG. 1 and the description of FIG. 2). For example, since the second front end circuitry 102, unlike the first front end circuitry 101 of FIG. 1, has a PA (e.g., the PA 122-1 and/or the PA 122-2 of FIG. 1), integrating the second front end circuitry 102 with the PA 121 like the second front end circuitry 202 may be more efficient than alternatives illustrated above. For example, since the PA 222-1 (corresponding to the PA 121) and the PA 222-2 (corresponding to the PA 122-1 and/or the PA 122-2 of FIG. 1) may be included within a single die of the second front end circuitry 202, integrating the second front end circuitry 102 with the PA 121 like the second front end circuitry 202 may have a positive factor in terms of cost. For example, the PA 222-1 (corresponding to the PA 121) and the PA 222-2 (corresponding to the PA 122-1 and/or the PA 122-2 of FIG. 1) may be included within a single die of the second front end circuitry 202, the second front end circuitry 202 may have a size, which is larger than that of the second front end circuitry 102, but have flexibility in arrangement.

The processor 290 may include various processing circuitry and be configured to control the first front end circuitry 201 and the second front end circuitry 202. For example, the processor 290 may include at least a portion of a processor 720 of FIG. 7 or may correspond to at least a portion of the processor 720 of FIG. 7. For example, the processor 290 may include an application processor (AP) and/or a communication processor (CP). The processor 290 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

For example, the processor 290 may be configured to control the first front end circuitry 201 to receive the first signal 295-1 through the antenna 291. For example, the processor 290 may be configured to control the first front end circuitry 201 and the second front end circuitry 202 (or control the second front end circuitry 202) to transmit the second signal 295-2 through the antenna 291. For example, the processor 290 may be configured to control the PA 222-1 to obtain Tx power of the second signal 295-2. For example, the processor 290 may be configured to control the first front end circuitry 201 (e.g., a duplexer (or filter) (not illustrated) in the first front end circuitry 201 and/or a switch (not illustrated) in the first front end circuitry 201), in order to form a transmission path for the second signal 295-2, which is transmitted through the antenna 291, within the first front end circuitry 201. For example, the processor 290 may control the first front end circuitry 201 and the second front end circuitry 202 (or control the second front end circuitry 202) to transmit the second signal 295-2 with Tx power obtained using the PA 222-1 through the antenna 291, while the third signal 295-3 is transmitted with Tx power obtained using the PA 222-2 through the antenna 292.

The electronic device 200 may further include the third front end circuitry 203.

The third front end circuitry 203 (or a third FEM 203) may be further used to transmit a fourth signal 295-4 on another uplink frequency range of the first frequency band through an antenna 293. For example, the third front end circuitry 203 may include a terminal (directly) connected to the antenna 293. For example, the third front end circuitry 203 may be disconnected from the antenna 291 and the antenna 292. For example, the third front end circuitry 203 may include a PA 223 configured to obtain Tx power of the fourth signal 295-4 to be transmitted through the antenna 293. For example, the PA 223 may be configured to be connected to the antenna 293, in order to obtain the Tx power of the fourth signal 295-4 to be transmitted through the antenna 293. For example, the PA 223 being connected to the antenna 293 may indicate the PA 223 not only being connected directly to the antenna 293, but also the PA 223 being connected to the antenna 293 through one or more components. For example, although not illustrated in FIG. 2, the third front end circuitry 203 may include one or more components, such as a filter (or duplexer) and/or a switch, on a transmission path from the PA 223 to the antenna 293. For example, the PA 223 may be disconnected from the antenna 291 and the antenna 292. For example, the third front end circuitry 203 may be configured to transmit the fourth signal 295-4 through the antenna 293. For example, the third front end circuitry 203 may be configured to transmit the fourth signal 295-4, while the second signal 295-2 is transmitted through the antenna 291, through the antenna 293. For example, the third front end circuitry 203 may be configured to transmit the fourth signal 295-4, while the third signal 295-3 is transmitted through the antenna 292, through the antenna 293. For example, the third front end circuitry 203 may be configured to transmit the fourth signal 295-4, while the first signal 295-1 is received through the antenna 291, through the antenna 293.

For example, the processor 290 may control the first front end circuitry 201 and the second front end circuitry 202 (or control the second front end circuitry 202) to transmit the second signal 295-2 with Tx power obtained using the PA 222-1 through the antenna 291, while the fourth signal 295-4 is transmitted with Tx power obtained using the PA 223 through the antenna 293.

Alternatively, the electronic device 200 may include an (or single) front end circuitry integrating the first front end circuitry 201 and the third front end circuitry 203. For example, the front end circuitry may include a transmission path from the PA 222-1 (located outside the front end circuitry) within the second front end circuitry202 to the antenna 291, the PA 223 (located inside the front end circuitry), and a transmission path from the PA 223 to the antenna 293. For example, when the electronic device 200 includes the first front end circuitry 201 and the third front end circuitry 203, the processor 290 may control the front end circuitry, which integrates the first front end circuitry 201 and the third front end circuitry 203, and the second front end circuitry 202 to transmit the second signal 295-2 with Tx power obtained using the PA 222-1 within the second front end circuitry 202 through the antenna 291, while the fourth signal 295-4 is transmitted with Tx power obtained using the PA 223 within the front end circuitry through the antenna 293.

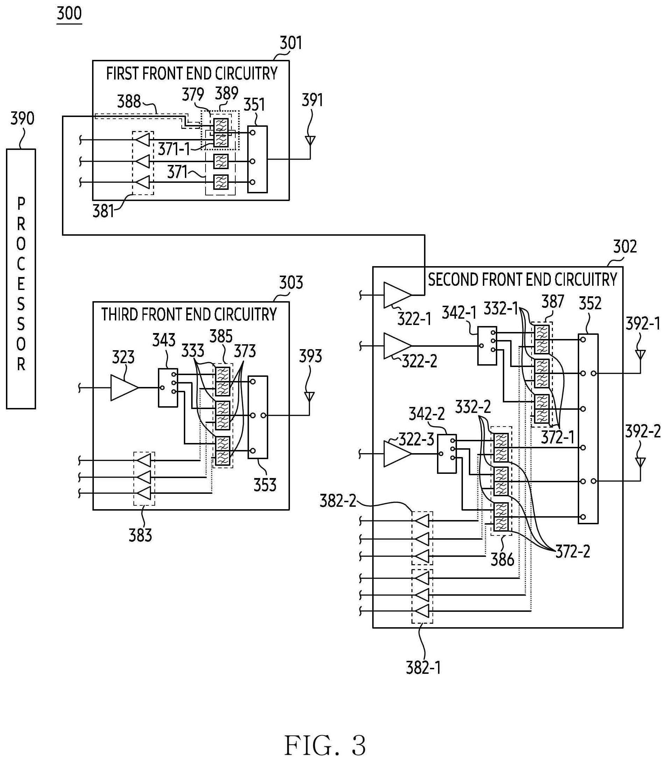

FIG. 3 illustrates an example of an electronic device that includes first front end circuitry, second front end circuitry including a PA connected to the first front end circuitry, and third front end circuitry.

Referring to FIG. 3, an electronic device 300 may be a portable device, such as a smartphone, a tablet, a laptop, a smart watch, and the like. However, it is not limited thereto. For example, the electronic device 300 may also be a fixed device such as a refrigerator, a TV, an IoT hub device, and the like. The electronic device 300 may correspond to at least a portion of an electronic device 701 to be illustrated in a description of FIG. 7.

The electronic device 300 may include first front end circuitry 301, second front end circuitry 302, third front end circuitry 303, and a processor (e.g., including processing circuitry) 390. The processor 390 may be the same as or similar to the processor 290 described above, and descriptions above of the processor 290 apply equally to the processor 390.

The first front end circuitry 301 (or a first FEM 301) may include LNAs 381 for receiving a signal on (or within) a downlink frequency range of the first frequency band through an antenna 391, filters 371 for passing the signal on the downlink frequency range of the first frequency band, a filter 379 for passing a signal on an uplink frequency range of the first frequency band, a switch 351, and a transmission path 388. For example, the filter 379 may be implemented as a duplexer 389 together with a filter 371-1 among the filters 371. For example, a PA 322-1 within the second front end circuitry 302 may be configured to be connected to the antenna 391 through the duplexer 389 and the switch 351. As a non-limiting example, any PA used to transmit a signal through the antenna 391 may not be located on (or within) the transmission path 388.

For example, the first front end circuitry 301 may be configured to receive the signal (e.g., corresponding to the first signal 295-1 of FIG. 2) on the downlink frequency range of the first frequency band through the antenna 391, according to control of the processor 390. For example, the processor 390 may control the switch 351 to connect the antenna 391 to one of the filters 371 to receive the signal on the downlink frequency range of the first frequency band through the antenna 391. For example, the processor 390 may control one of the LNAs 381 to amplify the signal on the downlink frequency range of the first frequency band through the antenna 391.

For example, the first front end circuitry 301 may be configured to transmit the signal (e.g., corresponding to the second signal 295-2 of FIG. 2) on the uplink frequency range of the first frequency band through the antenna 391, according to control of the processor 390. For example, the processor 390 may control the switch 351 to connect the antenna 391 to the filter 379 (or the duplexer 389). For example, the processor 390 may further control the second front end circuitry 302 (or a second FEM 302), which is not directly connected (or is indirectly connected) to the antenna 391, to transmit the signal on the uplink frequency range of the first frequency band through the antenna 391. For example, the processor 390 may control the PA 322-1 within the second front end circuitry 302 (or the second FEM 302) to obtain Tx power of the signal on the uplink frequency range of the first frequency band to be transmitted through the antenna 391. For example, the signal on the uplink frequency range of the first frequency band may be transmitted with Tx power obtained using the PA 322-1 through the transmission path 388 and the antenna 391.

The second front end circuitry 302 (or the second FEM 302) may include LNAs 382-1 for receiving a signal on (or within) a downlink frequency range of the second frequency band (e.g., a frequency band from 1 GHz to 2.3 GHz) through an antenna 392-1 (and/or an antenna 392-2), filters 372-1 for passing the signal on the downlink frequency range of the second frequency band, LNAs 382-2 for receiving a signal on (or within) a downlink frequency range of the third frequency band (e.g., a frequency band from 2.3 GHz to 3.4 GHz) through the antenna 392-2 (and/or the antenna 392-1), filters 372-2 for passing the signal on the downlink frequency range of the third frequency band, a PA 322-1 configured to obtain Tx power of the signal on the uplink frequency range of the first frequency band to be transmitted through the antenna 391, a PA 322-2 configured to obtain Tx power of a signal on an uplink frequency range of the second frequency band to be transmitted through the antenna 392-1 (and/or the antenna 392-2), a PA 322-3 configured to obtain Tx power of a signal on an uplink frequency range of the third frequency band to be transmitted through the antenna 392-2 (and/or the antenna 392-1), filters 332-1 for passing the signal on the uplink frequency range of the second frequency band, filters 332-2 for passing the signal on the uplink frequency range of the third frequency band, a switch 342-1 for connecting one of the filters 332-1 to the PA 322-2, and a switch 342-2 for connecting one of the filters 332-2 to the PA 322-3. As a non-limiting example, one of the filters 332-1 and one of the filters 372-1 may be implemented as a duplexer. For example, the second front end circuitry 302 may include duplexers 387. As a non-limiting example, one of the filters 332-2 and one of the filters 372-2 may be implemented as a duplexer. For example, the second front end circuitry 302 may include duplexers 386. For example, the second front end circuitry 302 may include a switch 352 for connecting the antenna 392-1 to one of the duplexers 387 and connecting the antenna 392-2 to one of the duplexers 386.

For example, unlike the PA 322-2 and the PA 322-3, the PA 322-1 may be disconnected from components, for transmitting a signal through the antenna 392-1 and the antenna 392-2, within the second front end circuitry 302. For example, the PA 322-1 may be configured to be disconnected from the antenna 392-1 and antenna 392-2 and connected to the antenna 391 through the first front end circuitry 301.

For example, the second front end circuitry 302 may be configured to obtain Tx power of the signal on the uplink frequency range of the first frequency band to be transmitted through the antenna 391, according to control of the processor 390. For example, the signal on the uplink frequency range of the first frequency band may be transmitted with Tx power obtained using the PA 322-1 through the first front end circuitry 301 and the antenna 391.

For example, the second front end circuitry 302 may be configured to transmit the signal on the uplink frequency range of the second frequency band through the antenna 392-1, according to control of the processor 390. For example, the processor 390 may control the PA 322-2 to obtain Tx power of the signal on the uplink frequency range of the second frequency band to be transmitted, while the signal on the uplink frequency range of the first frequency band is transmitted through the antenna 391, through the antenna 392-1. For example, the processor 390 may control the switch 342-1 and the switch 352 to transmit the signal on the uplink frequency range of the second frequency band through the antenna 392-1, while the signal on the uplink frequency range of the first frequency band is transmitted through the antenna 391.

For example, the second front end circuitry 302 may be configured to transmit the signal on the uplink frequency range of the third frequency band through the antenna 392-2, according to control of the processor 390. For example, the processor 390 may control the PA 322-3 to obtain Tx power of the signal on the uplink frequency range of the third frequency band to be transmitted, while the signal on the uplink frequency range of the first frequency band is transmitted through the antenna 391, through the antenna 392-2. For example, the processor 390 may control the switch 342-2 and the switch 352 to transmit the signal on the uplink frequency range of the third frequency band through the antenna 392-2, while the signal on the uplink frequency range of the first frequency band is transmitted through the antenna 391.

For example, the second front end circuitry 302 may be configured to receive the signal on the downlink frequency range of the second frequency band through the antenna 392-1, according to control of the processor 390. For example, the processor 390 may control the switch 352 to receive the signal on the downlink frequency range of the second frequency band through the antenna 392-1, while the signal on the uplink frequency range of the first frequency band is transmitted through the antenna 391. For example, the processor 390 may control one of the LNAs 382-1 to amplify the signal on the downlink frequency range of the second frequency band received, while the signal on the uplink frequency range of the first frequency band is transmitted through the antenna 391, through the antenna 392-1.

For example, the second front end circuitry 302 may be configured to receive the signal on the downlink frequency range of the third frequency band through the antenna 392-2, according to control of the processor 390. For example, the processor 390 may control the switch 352 to receive the signal on the downlink frequency range of the third frequency band through the antenna 392-2, while the signal on the uplink frequency range of the first frequency band is transmitted through the antenna 391. For example, the processor 390 may control one of the LNAs 382-2 to amplify the signal on the downlink frequency range of the third frequency band received, while the signal on the uplink frequency range of the first frequency band is transmitted through the antenna 391, through the antenna 392-2.

The third front end circuitry 303 (or a third FEM 303) may include LNAs 383 for receiving a signal on (or within) anther downlink frequency range of the first frequency band through an antenna 393, filters 373 for passing the signal on the other downlink frequency range of the first frequency band, a PA 323 configured to obtain Tx power of a signal on (or within) another uplink frequency range of the first frequency band to be transmitted through the antenna 393, filters 333 for passing the signal on the other uplink frequency range of the first frequency band, and a switch 343 for connecting the PA 323 to one of the filters 333. As a non-limiting example, one of the filters 333 and one of the filters 373 may be implemented as a duplexer. For example, the third front end circuitry 303 may include duplexers 385. For example, the third front end circuitry 303 may include a switch 353 for connecting the antenna 393 to one of the duplexers 385.

For example, the third front end circuitry 303 may be configured to transmit the signal on the other uplink frequency range of the first frequency band through the antenna 393, according to control of the processor 390. For example, the processor 390 may control the PA 323 to obtain Tx power of the signal on the other uplink frequency range of the first frequency band to be transmitted, while the signal on the uplink frequency range of the first frequency band is transmitted through the antenna 391, through the antenna 393. For example, the processor 390 may control the switch 343 and the switch 353 to transmit the signal on the other uplink frequency range of the first frequency band through the antenna 393, while the signal on the uplink frequency range of the first frequency band is transmitted through the antenna 391.

For example, the third front end circuitry 303 may be configured to receive the signal on the other downlink frequency range of the first frequency band through the antenna 393, according to control of the processor 390. For example, the processor 390 may control the switch 353 to receive the signal on the other downlink frequency range of the first frequency band through the antenna 393, while the signal on the uplink frequency range of the first frequency band is transmitted through the antenna 391. For example, the processor 390 may control one of the LNAs 383 to amplify the signal on the other downlink frequency range of the first frequency band received, while the signal on the uplink frequency range of the first frequency band is transmitted through the antenna 391, through the antenna 393.

Although not illustrated in FIG. 3, the electronic device 300 may further include front end circuitry (or a front end module), which includes terminals (directly) connected to other antennas distinguished from the antenna 391, antenna 392-1, antenna 392-2, and antenna 393, respectively, in order to receive a signal on another downlink frequency range of the second frequency band, transmit a signal on another uplink frequency range of the second frequency band, receive a signal on another downlink frequency range of the third frequency band, and transmit a signal on another uplink frequency range of the third frequency band. For example, the other antennas related to the front end circuitry may be spaced apart from the antenna 392-1 and the antenna 392-2. For example, unlike the second front end circuitry 302, the front end circuitry may not include a PA connected to another front end circuitry, such as the PA 322-1.

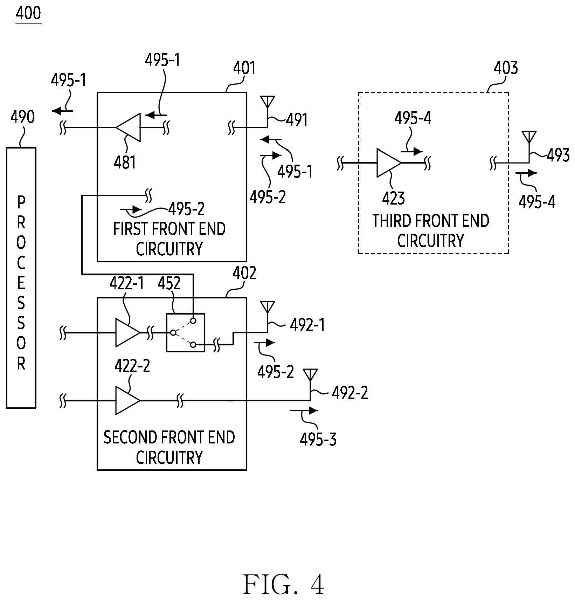

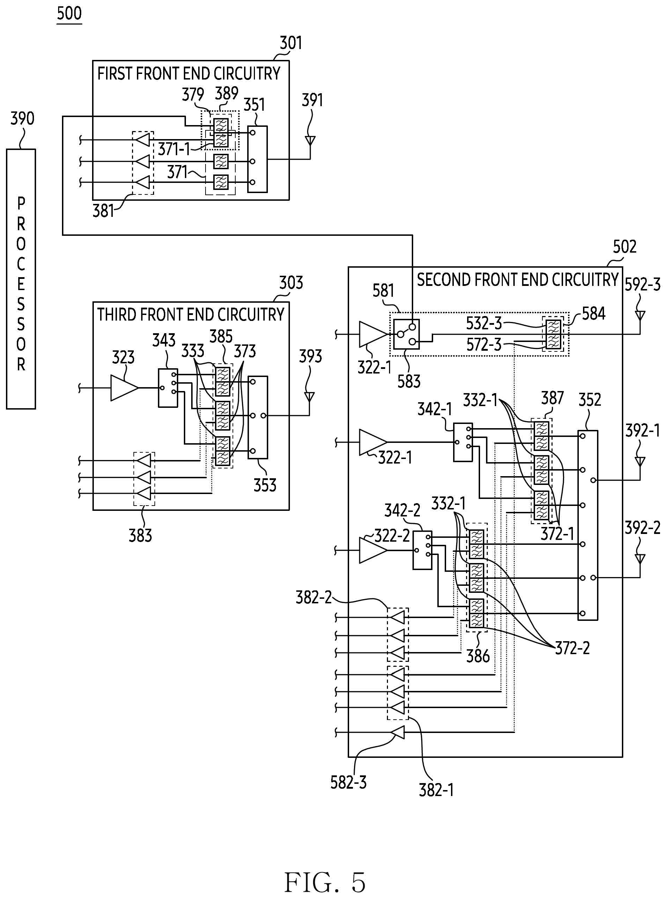

A PA, such as the PA 222-1 of FIG. 2 and the PA 322-1 of FIG. 3, may be arranged within an electronic device (e.g., portable device), together with components (e.g., switches) for antenna switched diversity. The components are illustrated in descriptions of FIGS. 4 and 5.

FIG. 4 illustrates an example of an electronic device that includes first front end circuitry and second front end circuitry including a PA connectable to the first front end circuitry.

Referring to FIG. 4, an electronic device 400 may be a portable device, such as a smartphone, a tablet, a laptop, a smart watch, and the like. However, it is not limited thereto. For example, the electronic device 400 may be a fixed device such as a refrigerator, a TV, or an IoT hub device. The electronic device 400 may correspond to at least a portion of an electronic device 701 illustrated in a description of FIG. 7.

The electronic device 400 may include first front end circuitry 401, second front end circuitry 402, and a processor (e.g., including processing circuitry) 490. The processor 490 may be the same as or similar to the processor 290 described above, and descriptions above of the processor 290 apply equally to the processor 490.

The first front end circuitry 401 (or a first FEM 401) may include an LNA 481 (e.g., corresponding to the LNA 281 of FIG. 2) for a first signal 495-1 on a downlink frequency range of the first frequency band received through an antenna 491 and a transmission path (not illustrated) for a second signal 495-2 on an uplink frequency range of the first frequency band transmitted through the antenna 491. For example, the transmission path may be configured to be connected to a switch 452 for connection with a PA 422-1.

The second front end circuitry 402 (or a second FEM 402) may include a PA 422-1 for obtaining Tx power of the second signal 495-2 transmitted through an antenna 492-1, a PA 422-2 (e.g., corresponding to the PA 222 of FIG. 2) for obtaining Tx power of a third signal 495-3 on an uplink frequency range of the second frequency band transmitted through an antenna 492-2, and a switch 452 for selecting an antenna to be connected to the PA 422-1 from among the antenna 491 and the antenna 492-1.

The processor 490 may control the first front end circuitry 401 to receive the first signal 495-1. For example, the processor 490 may control the LNA 481 to amplify the first signal 495-1 received through the antenna 491.

The processor 490 may control the second front end circuitry 402 to transmit the second signal 495-2. For example, the processor 490 may control the PA 422-1 to obtain or generate Tx power of the second signal 495-2 to be transmitted through the antenna 491 or the antenna 492-1. For example, the processor 490 may control the switch 452 to connect the PA 422-1 to the antenna 491 among the antenna 491 and the antenna 492-1, in order to transmit the second signal 495-2 with Tx power obtained using the PA 422-1 through the antenna 491. For example, the processor 490 may control the switch 452 to connect the PA 422-1 to the antenna 492-1 among the antenna 491 and the antenna 492-1, in order to transmit the second signal 495-2 with Tx power obtained using the PA 422-1 through the antenna 492-1. As a non-limiting example, the second signal 495-2 may be transmitted, while the first signal 495-1 is received through the antenna 491, through the antenna 492-1.

The processor 490 may control the second front end circuitry 402 to transmit the third signal 495-3. For example, the processor 490 may control the PA 422-2 to obtain or generate Tx power of the third signal 495-3 to be transmitted through the antenna 492-2. For example, the third signal 495-3 may be transmitted, while the second signal 495-2 is transmitted through the antenna 491, through the antenna 492-2. For example, the third signal 495-3 may be transmitted, while the second signal 495-2 is transmitted through the antenna 492-1, through the antenna 492-2.

As a non-limiting example, the processor 490 may obtain information on communication quality related to the second signal 495-2 (or a state of the second signal 495-2), while the second signal 495-2 is transmitted through the antenna 492-1. For example, the processor 490 may control the switch 452 to change an antenna connected to the PA 422-1 from the antenna 492-1 to the antenna 491, based on the information.

As a non-limiting example, the processor 490 may obtain information on communication quality related to the second signal 495-2 (or a state of the second signal 495-2) while the second signal 495-2 is transmitted through the antenna 491. For example, the processor 490 may control the switch 452 to change an antenna connected to the PA 422-1 from the antenna 491 to the antenna 492-1, based on the information.

The electronic device 400 may further include third front end circuitry 403 (or a third FEM 403).

The third front end circuitry 403 may include a PA 423 to obtain or generate Tx power of a fourth signal 495-4 on another uplink frequency range of the first frequency band to be transmitted through the antenna 493.

The processor 490 may control the third front end circuitry 403 to transmit the fourth signal 495-4. For example, the processor 490 may control the PA 423 to obtain or generate Tx power of the fourth signal 495-4 to be transmitted through the antenna 493. For example, the fourth signal 495-4 may be transmitted, while the second signal 495-2 is transmitted through the antenna 491, through the antenna 493. For example, the fourth signal 495-4 may be transmitted, while the second signal 495-2 is transmitted through the antenna 492-1, through the antenna 493.

As a non-limiting example, the processor 490 may obtain information on communication quality related to the second signal 495-2 (or a state of the second signal 495-2) transmitted, while the fourth signal 495-4 is transmitted, through the antenna 492-1. For example, the processor 490 may control the switch 452 to change an antenna connected to the PA 422-1 from the antenna 492-1 to the antenna 491, based on the information.

As a non-limiting example, the processor 490 may obtain information on communication quality related to the second signal 495-2 (or a state of the second signal 495-2) transmitted, while the fourth signal 495-4 is transmitted, through the antenna 491. For example, the processor 490 may control the switch 452 to change an antenna connected to the PA 422-1 from the antenna 491 to the antenna 492-1, based on the information.

FIG. 5 illustrates an example of an electronic device that includes first front end circuitry, second front end circuitry including a PA connectable to the first front end circuitry, and third front end circuitry.

Referring to FIG. 5, an electronic device 500 may be a portable device, such as a smartphone, a tablet, a laptop, a smart watch, and the like. However, it is not limited thereto. For example, the electronic device 500 may be a fixed device (or immobile device, or immovable device) such as a refrigerator, a TV, or an IoT hub device. The electronic device 500 may correspond to at least a portion of an electronic device 701 illustrated in a description of FIG. 7.

The electronic device 500 may include first front end circuitry 301, second front end circuitry 502, and a processor 590(e.g., including processing circuitry). The processor 590 may be the same as or similar to the processor 290 described above, and descriptions above of the processor 290 apply equally to the processor 590.

The first front end circuitry 301 may correspond to the first front end circuitry 301 illustrated in the description of FIG. 3.

The second front end circuitry 502 may be front end circuitry in which additional components for antenna switched diversity are added to the second front end circuitry 302 illustrated in the description of FIG. 3. For example, the second front end circuitry 502 may further include a switch 583 connected to a PA 322-1, a filter 532-3, a filter 572-3, an LNA 582-3, and an antenna 592-3.

For example, the PA 322-1 within the second front end circuitry 502 may be configured to be connected to an antenna 391 through the switch 583. For example, the PA 322-1 within the second front end circuitry 502 may be configured to be connected to the antenna 592-3 through the switch 583.

For example, the filter 532-3 and the filter 572-3 within the second front end circuitry 502 may be implemented as a duplexer 584.

For example, the processor 590 may control the LNA 582-3 to amplify a signal received through the antenna 592-3 and the duplexer 584 (or the filter 572-3).

For example, the processor 590 may control the PA 322-1 to obtain Tx power of the signal on the uplink frequency range of the first frequency band. For example, the processor 590 may control the switch 583 to connect a duplexer 389 among the duplexer 389 and the duplexer 584 to the PA 322-1, in order to transmit the signal on the uplink frequency range of the first frequency band with Tx power obtained using the PA 322-1 through the antenna 391. For example, the processor 590 may control the switch 583 to connect the duplexer 584 among the duplexer 389 and the duplexer 584 to the PA 322-1, in order to transmit the signal on the uplink frequency range of the first frequency band with Tx power obtained using the PA 322-1 through the antenna 592-3. For example, antenna switched diversity performed through control of the switch 583 may be used within dual connectivity.

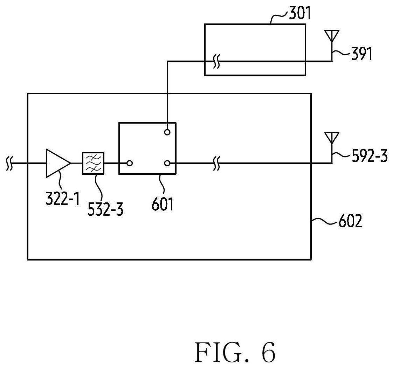

As a non-limiting example, components 581 including the switch 583 and the duplexer 584 may be replaced with other components. Examples of the other components are illustrated and described in greater detail below with reference to FIG. 6.

FIG. 6 illustrates an example of another switch that replaces the switch in FIG. 5.

Referring to FIG. 6, second front end circuitry 602 may include a filter 532-3 directly connected to a PA 322-1 and a switch 601 for connecting one of an antenna 391 and an antenna 592-3 to the filter 532-3. For example, unlike a switch 583, the switch 601 may be located between the filter 532-3 and antennas (e.g., the antenna 391 and the antenna 592-3). For example, the switch 601 may be configured to connect the antenna 391 to the filter 532-3, in order to connect the PA 322-1 to the antenna 391. For example, the switch 601 may be configured to connect the antenna 592-3 to the filter 532-3, in order to connect the PA 322-1 to the antenna 592-3. For example, the switch 601 may operate according to control of a processor 590.

Components according to the above descriptions may be included in an electronic device illustrated in a description of FIG. 7. Operations according to the above descriptions may be executed in an electronic device illustrated and described in greater detail below with reference to FIG. 7.

FIG. 7 is a block diagram illustrating an electronic device 701 in a network environment 700 according to various embodiments. Referring to FIG. 7, the electronic device 701 in the network environment 700 may communicate with an electronic device 702 via a first network 798 (e.g., a short-range wireless communication network), or at least one of an electronic device 704 or a server 708 via a second network 799 (e.g., a long-range wireless communication network). According to an embodiment, the electronic device 701 may communicate with the electronic device 704 via the server 708. According to an embodiment, the electronic device 701 may include a processor 720, memory 730, an input module 750, a sound output module 755, a display module 760, an audio module 770, a sensor module 776, an interface 777, a connecting terminal 778, a haptic module 779, a camera module 780, a power management module 788, a battery 789, a communication module 790, a subscriber identification module (SIM) 796, or an antenna module 797. In various embodiments, at least one of the components (e.g., the connecting terminal 778) may be omitted from the electronic device 701, or one or more other components may be added in the electronic device 701. In various embodiments, some of the components (e.g., the sensor module 776, the camera module 780, or the antenna module 797) may be implemented as a single component (e.g., the display module 760).

The processor 720 may execute, for example, software (e.g., a program 740) to control at least one other component (e.g., a hardware or software component) of the electronic device 701 coupled with the processor 720, and may perform various data processing or computation. According to an embodiment, as at least part of the data processing or computation, the processor 720 may store a command or data received from another component (e.g., the sensor module 776 or the communication module 790) in volatile memory 732, process the command or the data stored in the volatile memory 732, and store resulting data in non-volatile memory 734. According to an embodiment, the processor 720 may include a main processor 721 (e.g., a central processing unit (CPU) or an application processor (AP)), or an auxiliary processor 723 (e.g., a graphics processing unit (GPU), a neural processing unit (NPU), an image signal processor (ISP), a sensor hub processor, or a communication processor (CP)) that is operable independently from, or in conjunction with, the main processor 721. For example, when the electronic device 701 includes the main processor 721 and the auxiliary processor 723, the auxiliary processor 723 may be adapted to consume less power than the main processor 721, or to be specific to a specified function. The auxiliary processor 723 may be implemented as separate from, or as part of the main processor 721.

The auxiliary processor 723 may control at least some of functions or states related to at least one component (e.g., the display module 760, the sensor module 776, or the communication module 790) among the components of the electronic device 701, instead of the main processor 721 while the main processor 721 is in an inactive (e.g., sleep) state, or together with the main processor 721 while the main processor 721 is in an active state (e.g., executing an application). According to an embodiment, the auxiliary processor 723 (e.g., an image signal processor or a communication processor) may be implemented as part of another component (e.g., the camera module 780 or the communication module 790) functionally related to the auxiliary processor 723. According to an embodiment, the auxiliary processor 723 (e.g., the neural processing unit) may include a hardware structure specified for artificial intelligence model processing. An artificial intelligence model may be generated by machine learning. Such learning may be performed, e.g., by the electronic device 701 where the artificial intelligence is performed or via a separate server (e.g., the server 708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 730 may store various data used by at least one component (e.g., the processor 720 or the sensor module 776) of the electronic device 701. The various data may include, for example, software (e.g., the program 740) and input data or output data for a command related thereto. The memory 730 may include the volatile memory 732 or the non-volatile memory 734.

The program 740 may be stored in the memory 730 as software, and may include, for example, an operating system (OS) 742, middleware 744, or an application 746.

The input module 750 may receive a command or data to be used by another component (e.g., the processor 720) of the electronic device 701, from the outside (e.g., a user) of the electronic device 701. The input module 750 may include, for example, a microphone, a mouse, a keyboard, a key (e.g., a button), or a digital pen (e.g., a stylus pen).

The sound output module 755 may output sound signals to the outside of the electronic device 701. The sound output module 755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 760 may visually provide information to the outside (e.g., a user) of the electronic device 701. The display module 760 may include, for example, a display, a hologram device, or a projector and control circuitry to control a corresponding one of the display, hologram device, and projector. According to an embodiment, the display module 760 may include a touch sensor adapted to detect a touch, or a pressure sensor adapted to measure the intensity of force incurred by the touch.

The audio module 770 may convert a sound into an electrical signal and vice versa. According to an embodiment, the audio module 770 may obtain the sound via the input module 750, or output the sound via the sound output module 755 or a headphone of an external electronic device (e.g., an electronic device 702) directly (e.g., wiredly) or wirelessly coupled with the electronic device 701.

The sensor module 776 may detect an operational state (e.g., power or temperature) of the electronic device 701 or an environmental state (e.g., a state of a user) external to the electronic device 701, and then generate an electrical signal or data value corresponding to the detected state. According to an embodiment, the sensor module 776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 777 may support one or more specified protocols to be used for the electronic device 701 to be coupled with the external electronic device (e.g., the electronic device 702) directly (e.g., wiredly) or wirelessly. According to an embodiment, the interface 777 may include, for example, a high definition multimedia interface (HDMI), a universal serial bus (USB) interface, a secure digital (SD) card interface, or an audio interface.

A connecting terminal 778 may include a connector via which the electronic device 701 may be physically connected with the external electronic device (e.g., the electronic device 702). According to an embodiment, the connecting terminal 778 may include, for example, an HDMI connector, a USB connector, a SD card connector, or an audio connector (e.g., a headphone connector).

The haptic module 779 may convert an electrical signal into a mechanical stimulus (e.g., a vibration or a movement) or electrical stimulus which may be recognized by a user via his tactile sensation or kinesthetic sensation. According to an embodiment, the haptic module 779 may include, for example, a motor, a piezoelectric element, or an electric stimulator.

The camera module 780 may capture a still image or moving images. According to an embodiment, the camera module 780 may include one or more lenses, image sensors, image signal processors, or flashes.

The power management module 788 may manage power supplied to the electronic device 701. According to an embodiment, the power management module 788 may be implemented as at least part of, for example, a power management integrated circuit (PMIC).

The battery 789 may supply power to at least one component of the electronic device 701. According to an embodiment, the battery 789 may include, for example, a primary cell which is not rechargeable, a secondary cell which is rechargeable, or a fuel cell.

The communication module 790 may support establishing a direct (e.g., wired) communication channel or a wireless communication channel between the electronic device 701 and the external electronic device (e.g., the electronic device 702, the electronic device 704, or the server 708) and performing communication via the established communication channel. The communication module 790 may include one or more communication processors that are operable independently from the processor 720 (e.g., the application processor (AP)) and supports a direct (e.g., wired) communication or a wireless communication. According to an embodiment, the communication module 790 may include a wireless communication module 792 (e.g., a cellular communication module, a short-range wireless communication module, or a global navigation satellite system (GNSS) communication module) or a wired communication module 794 (e.g., a local area network (LAN) communication module or a power line communication (PLC) module). A corresponding one of these communication modules may communicate with the external electronic device via the first network 798 (e.g., a short-range communication network, such as Bluetooth^{™}, wireless-fidelity (Wi-Fi) direct, or infrared data association (IrDA)) or the second network 799 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 792 may identify and authenticate the electronic device 701 in a communication network, such as the first network 798 or the second network 799, using subscriber information (e.g., international mobile subscriber identity (IMSI)) stored in the subscriber identification module 796.

The wireless communication module 792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 792 may support a high-frequency band (e.g., the mmWave band) to achieve, e.g., a high data transmission rate. The wireless communication module 792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 792 may support various requirements specified in the electronic device 701, an external electronic device (e.g., the electronic device 704), or a network system (e.g., the second network 799). According to an embodiment, the wireless communication module 792 may support a peak data rate (e.g., 20Gbps or more) for implementing eMBB, loss coverage (e.g., 764dB or less) for implementing mMTC, or U-plane latency (e.g., 0.5ms or less for each of downlink (DL) and uplink (UL), or a round trip of 7ms or less) for implementing URLLC.

The antenna module 797 may transmit or receive a signal or power to or from the outside (e.g., the external electronic device) of the electronic device 701. According to an embodiment, the antenna module 797 may include an antenna including a radiating element including a conductive material or a conductive pattern formed in or on a substrate (e.g., a printed circuit board (PCB)). According to an embodiment, the antenna module 797 may include a plurality of antennas (e.g., array antennas). In such a case, at least one antenna appropriate for a communication scheme used in the communication network, such as the first network 798 or the second network 799, may be selected, for example, by the communication module 790 (e.g., the wireless communication module 792) from the plurality of antennas. The signal or the power may then be transmitted or received between the communication module 790 and the external electronic device via the selected at least one antenna. According to an embodiment, another component (e.g., a radio frequency integrated circuit (RFIC)) other than the radiating element may be additionally formed as part of the antenna module 797.

According to various embodiments, the antenna module 797 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 701 and the external electronic device 704 via the server 708 coupled with the second network 799. Each of the electronic devices 702 or 704 may be a device of a same type as, or a different type, from the electronic device 701. According to an embodiment, all or some of operations to be executed at the electronic device 701 may be executed at one or more of the external electronic devices 702, 704, or 708. For example, if the electronic device 701 should perform a function or a service automatically, or in response to a request from a user or another device, the electronic device 701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 701. The electronic device 701 may provide the outcome, with or without further processing of the outcome, as at least part of a reply to the request. To that end, a cloud computing, distributed computing, mobile edge computing (MEC), or client-server computing technology may be used, for example. The electronic device 701 may provide ultra low-latency services using, e.g., distributed computing or mobile edge computing. In an embodiment, the external electronic device 704 may include an internet-of-things (IoT) device. The server 708 may be an intelligent server using machine learning and/or a neural network. According to an embodiment, the external electronic device 704 or the server 708 may be included in the second network 799. The electronic device 701 may be applied to intelligent services (e.g., smart home, smart city, smart car, or healthcare) based on 5G communication technology or IoT-related technology.

According to an example embodiment, an electronic device (e.g., the electronic device 200) may comprise: a first antenna (e.g., the antenna 291), a second antenna (e.g., the antenna 292), first front end circuitry (e.g., the first front end circuitry 201) including a low noise amplifier (LNA) configured to be connected to the first antenna to amplify a first signal on a downlink frequency range of a first frequency band received through the first antenna, second front end circuitry (e.g., the second front end circuitry 202) that includes a first power amplifier (PA) (e.g., the PA 222-1) configured to be connected to the first antenna through the first front end circuitry to obtain transmit (Tx) power of a second signal on an uplink frequency range of the first frequency band transmitted through the first antenna, and a second PA (e.g., the PA 222-2) configured to be connected to the second antenna to obtain a Tx power of a third signal on an uplink frequency range of a second frequency band transmitted through the second antenna. The first front end circuitry may be configured to transmit the second signal with Tx power obtained using the first PA in the second front end circuitry configured to be connected to the first antenna.

For example, an output terminal of the first PA may be connected to an input terminal of the first front end circuitry and disconnected from the second antenna.

For example, the first front end circuitry may include a duplexer. For example, both the LNA in the first front end circuitry and the first PA in the second front end circuitry may be configured to be connected through the duplexer to the first antenna.

For example, the electronic device may include at least one processor, comprising processing circuitry (e.g., the processor 290), and memory (e.g., the memory 730) configured to store instructions. The at least one processor, individually and/or collectively, may be configured to, when executing the instructions, control the second front end circuitry to obtain, using the first PA, Tx power of the second signal to be transmitted through the first antenna.

For example, the electronic device may comprise a third antenna (e.g., the antenna 293), third front end circuitry (e.g., the third front end circuitry 203) including a PA (e.g., the PA 223) configured to be connected to the third antenna to obtain Tx power of a fourth signal on another uplink frequency range of the first frequency band. The at least one processor, individually and/or collectively, may be configured to, when executing the instructions, control the first front end circuitry and the second front end circuitry to transmit, while the fourth signal is transmitted with Tx power obtained using the PA in the third front end circuitry through the third antenna, the second signal with Tx power obtained using the first PA in the second front end circuitry through the first antenna.

For example, the at least one processor, individually and/or collectively, may be configured to, when executing the instructions, control the first front end circuitry and the second front end circuitry to transmit, while the third signal is transmitted with Tx power obtained using the second PA in the second front end circuitry through the second antenna, the second signal with Tx power obtained using the first PA in the second front end circuitry through the first antenna.

For example, the electronic device may comprise a third antenna and at least one processor, comprising processing circuitry. For example, the first front end circuitry may include a PA configured to be connected to the third antenna to obtain Tx power of a fourth signal on another uplink frequency range of the first frequency band. For example, the at least one processor, individually and/or collectively, may be configured to, when executing the instructions, control the first front end circuitry and the second front end circuitry to transmit, while the fourth signal is transmitted with Tx power obtained using the PA in the first front end circuitry through the third antenna, the second signal with Tx power obtained using the first PA in the second front end circuitry through the first antenna.

For example, the first front end circuitry from among the first front end circuitry and the second front end circuitry may not include a PA configured to obtain Tx power of a signal.

For example, both the first PA and the second PA may be included in a single die in the second front end circuitry.

For example, the first frequency band may be a frequency band less than 1 gigahertz (GHz), and the second frequency band may be a frequency band greater than 1 gigahertz (GHz).

According to an example embodiment, an electronic device (e.g., the electronic device 200) may comprise: a first antenna (e.g., the antenna 291), a second antenna (e.g., the antenna 292), a third antenna (e.g., the antenna 293), first front end circuitry (e.g., the first front end circuitry 201) including a terminal connected to the first antenna from among the first antenna, the second antenna, and the third antenna, and second front end circuitry (e.g., the second front end circuitry 202) including a terminal connected to the second antenna from among the first antenna, the second antenna, and the third antenna. The second front end circuitry may include a first power amplifier (PA) (e.g., the PA 222-1) configured to be connected to the first antenna through the first front end circuitry and disconnected from the second antenna, and a second PA (e.g., the PA 222-2) configured to be connected to the second antenna. The electronic device may comprise third front end circuitry (e.g., the third front end circuitry 203) including a terminal connected to the third antenna from among the first antenna, the second antenna, and the third antenna. The third front end circuitry may include a PA (e.g., the PA 223) configured to be connected to the third antenna. The electronic device may comprise at least one processor, comprising processing circuitry, and memory configured to store instructions. The instructions, when executed by the at least one processor, individually and/or collectively, may cause the electronic device to: control the first PA in the second front end circuitry to obtain transmit (Tx) power of a second signal on a second uplink frequency range of a first frequency band transmitted, while a first signal on a first uplink frequency range of the first frequency band is transmitted with Tx power obtained using the PA in the third front end circuitry through the third antenna, through the first antenna, and control the second PA in the second front end circuitry to obtain Tx power of a third signal on an uplink frequency range of a second frequency band transmitted, while the first signal is transmitted with Tx power obtained using the PA in the third front end circuitry through the third antenna, through the second antenna.

For example, the instructions, when executed by the at least one processor, individually and/or collectively, may cause the electronic device to control the first PA in the second front end circuitry to obtain Tx power of the second signal transmitted, while the third signal is transmitted with Tx power obtained using the second PA in the second front end circuitry through the second antenna connected to the second front end circuitry, through the first antenna.

For example, the first front end circuitry may include a first duplexer, and the second front end circuitry may include a second duplexer. The first PA in the second front end circuitry may be connected to the first duplexer in the first front end circuitry from among the first duplexer in the first front end circuitry and the second duplexer in the second front end circuitry, and the second PA in the second front end circuity may be connected to the second duplexer in the second front end circuitry from among the first duplexer in the first front end circuitry and the second duplexer in the second front end circuitry.

For example, both the first PA and the second PA may be included in a single die in the second front end circuitry.

For example, the first front end circuitry from among the first front end circuitry, the second front end circuitry, and the third front end circuitry may not include a PA configured to obtain Tx power of a signal.

According to an example embodiment, an electronic device (e.g., the electronic device 400) may comprise: a first antenna (e.g., the antenna 491), a second antenna (e.g., the antenna 492-1), a third antenna (e.g., the antenna 492-2), first front end circuitry (e.g., the first front end circuitry 401) including a terminal connected to the first antenna, second front end circuitry (e.g., the second front end circuitry 402) including terminals respectively connected to the second antenna and the third antenna, and at least one processor, comprising processing circuitry (e.g., the processor 490). The second front end circuitry may include a first power amplifier (PA) (e.g., the PA 422-1) configured to obtain Tx power of a first signal on an uplink frequency range of a first frequency band, a second PA (e.g., the PA 422-2) configured to obtain Tx power of a second signal on an uplink frequency range of a second frequency band, and a switch (e.g., the switch 452) configured to connect the first PA to an antenna from among the first antenna and the second antenna. The At least one processor, individually and/or collectively, may be configured to, while the second signal is transmitted with Tx power obtained using the second PA in the second front end circuitry through the third antenna, control the switch to connect the first PA in the second front end circuitry to the first antenna from among the first antenna and the second antenna to transmit the first signal with Tx power obtained using the first PA in the second front end circuitry through the first antenna from among the first antenna and the second antenna, or control the switch to connect the first PA in the second front end circuitry to the second antenna from among the first antenna and the second antenna to transmit the first signal with Tx power obtained using the first PA in the second front end circuitry through the second antenna from among the first antenna and the second antenna.

For example, the at least one processor, individually and/or collectively, may be configured to identify a state of the first signal transmitted while the second signal is transmitted, and control, based on the state, the switch to change an antenna connected to the first PA in the second front end circuitry from the second antenna to the first antenna.

For example, the electronic device may comprise: a fourth antenna (e.g., the antenna 493) and third front end circuitry (e.g., the third front end circuitry 403) including a terminal connected to the fourth antenna. For example, the third front end circuitry may include a PA (e.g., the PA 423) configured to obtain Tx power of a third signal on another uplink frequency range of the first frequency band. For example, the at least one processor, individually and/or collectively, may be configured to, while the third signal is transmitted with Tx power obtained using the PA in the third front end circuitry through the fourth antenna, control the switch to connect the first PA in the second front end circuitry to the first antenna from among the first antenna and the second antenna to transmit the first signal with Tx power obtained using the first PA in the second front end circuitry through the first antenna from among the first antenna and the second antenna, or control the switch to connect the first PA in the second front end circuitry to the second antenna from among the first antenna and the second antenna to transmit the first signal with Tx power obtained using the first PA in the second front end circuitry through the second antenna from among the first antenna and the second antenna.

For example, the at least one processor, individually and/or collectively, may be configured to identify a state of the first signal transmitted while the third signal is transmitted, and control, based on the state, the switch to change an antenna connected to the first PA in the second front end circuitry from the second antenna to the first antenna.

For example, the first front end circuitry may include a duplexer configured to be connected to the first antenna, and the second front end circuitry may include a duplexer configured to be connected to the second antenna, and the switch may include a first terminal connected to an output terminal of the first PA in the second front end circuitry, a second terminal connected to the duplexer in the first front end circuitry, and a third terminal connected to the duplexer in the second front end circuitry. For example, the at least one processor, individually and/or collectively, may be configured to connect, by controlling the switch to connect the second terminal to the first terminal, the PA in the second front end circuitry to the first antenna, and connect, by controlling the switch to connect the third terminal to the first terminal, the PA in the second front end circuitry to the second antenna.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 740) including one or more instructions that are stored in a storage medium (e.g., internal memory 736 or external memory 738) that is readable by a machine (e.g., the electronic device 701). For example, a processor (e.g., the processor 720) of the machine (e.g., the electronic device 701) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device comprising:
a first antenna;
a second antenna;
first front end circuitry including a low noise amplifier (LNA) configured to be connected to the first antenna to amplify a first signal on a downlink frequency range of a first frequency band received through the first antenna; and
second front end circuitry including:
a first power amplifier (PA) configured to be connected to the first antenna through the first front end circuitry to obtain transmit (Tx) power of a second signal on an uplink frequency range of the first frequency band transmitted through the first antenna; and
a second PA configured to be connected to the second antenna to obtain Tx power of a third signal on an uplink frequency range of a second frequency band transmitted through the second antenna,
wherein the first front end circuitry is configured to transmit the second signal with Tx power obtained using the first PA in the second front end circuitry configured to be connected to the first antenna.

2. The electronic device of claim 1, wherein an output terminal of the first PA is connected to an input terminal of the first front end circuitry and is disconnected from the second antenna.

3. The electronic device of claim 1, wherein the first front end circuitry further includes a duplexer, and
wherein both the LNA in the first front end circuitry and the first PA in the second front end circuitry are configured to be connected through the duplexer to the first antenna.

4. The electronic device of claim 1, further comprising:
memory,
wherein the memory stores instructions for controlling the second front end circuitry to obtain, using the first PA, Tx power of the second signal to be transmitted through the first antenna.

5. The electronic device of claim 1, further comprising:
a third antenna;
third front end circuitry including a PA configured to be connected to the third antenna to obtain Tx power of a fourth signal on another uplink frequency range of the first frequency band;
memory storing instructions; and
at least one processor, comprising processing circuitry,
wherein the instructions, when executed by the at least one processor individually and/or collectively, cause the electronic device to:
control the first front end circuitry and the second front end circuitry to transmit, while the fourth signal is transmitted with Tx power obtained using the PA in the third front end circuitry through the third antenna, the second signal with Tx power obtained using the first PA in the second front end circuitry through the first antenna.

6. The electronic device of claim 5, wherein the instructions, when executed by the at least one processor individually and/or collectively, cause the electronic device to control the first front end circuitry and the second front end circuitry to transmit, while the third signal is transmitted with Tx power obtained using the second PA in the second front end circuitry through the second antenna, the second signal with Tx power obtained using the first PA in the second front end circuitry through the first antenna.

7. The electronic device of claim 1, further comprising:
a third antenna;
memory storing instructions; and
at least one processor, comprising processing circuitry;
wherein the first front end circuitry further includes a PA configured to be connected to the third antenna to obtain Tx power of a fourth signal on another uplink frequency range of the first frequency band, and
wherein the instructions, when executed by the at least one processor individually and/or collectively, cause the electronic device to control the first front end circuitry and the second front end circuitry to transmit, while the fourth signal is transmitted with Tx power obtained using the PA in the first front end circuitry through the third antenna, the second signal with Tx power obtained using the first PA in the second front end circuitry through the first antenna.

8. The electronic device of claim 1, wherein the first front end circuitry from among the first front end circuitry and the second front end circuitry does not include any PA configured to obtain Tx power of a signal.

9. The electronic device of claim 1, wherein both the first PA and the second PA are included in a single die in the second front end circuitry.

10. The electronic device of claim 1, wherein the first frequency band is a frequency band less than 1 gigahertz (GHz), and
wherein the second frequency band is a frequency band greater than 1 gigahertz (GHz).

11. An electronic device comprising:
a first antenna;
a second antenna;
a third antenna;
first front end circuitry including a terminal connected to the first antenna from among the first antenna, the second antenna, and the third antenna;
second front end circuitry including:
a terminal connected to the second antenna from among the first antenna, the second antenna, and the third antenna;
a first power amplifier (PA) configured to be connected to the first antenna through the first front end circuitry and disconnected from the second antenna; and
a second PA configured to be connected to the second antenna;
third front end circuitry including:
a terminal connected to the third antenna from among the first antenna, the second antenna, and the third antenna; and
a PA configured to be connected to the third antenna;
memory storing instructions; and
at least one processor, comprising processing circuitry,
wherein the instructions, when executed by the at least one processor individually and/or collectively, cause the electronic device to:
control the first PA in the second front end circuitry to obtain transmit (Tx) power of a second signal on a second uplink frequency range of a first frequency band transmitted, while a first signal on a first uplink frequency range of the first frequency band is transmitted with Tx power obtained using the PA in the third front end circuitry through the third antenna, through the first antenna; and
control the second PA in the second front end circuitry to obtain Tx power of a third signal on an uplink frequency range of a second frequency band that is transmitted, while the first signal is transmitted with Tx power obtained using the PA in the third front end circuitry through the third antenna, through the second antenna.

12. The electronic device of claim 11, wherein the instructions, when executed by the at least one processor individually and/or collectively, cause the electronic device to:
control the first PA in the second front end circuitry to obtain Tx power of the second signal transmitted, while the third signal is transmitted with Tx power obtained using the second PA in the second front end circuitry through the second antenna connected to the second front end circuitry, through the first antenna.

13. The electronic device of claim 11, wherein the first front end circuitry includes a first duplexer,
wherein the second front end circuitry includes a second duplexer,
wherein the first PA in the second front end circuitry is connected to the first duplexer in the first front end circuitry from among the first duplexer in the first front end circuitry and the second duplexer in the second front end circuitry, and
wherein the second PA in the second front end circuity is connected to the second duplexer in the second front end circuitry from among the first duplexer in the first front end circuitry and the second duplexer in the second front end circuitry.

14. The electronic device of claim 11, wherein both the first PA and the second PA are included in a single die in the second front end circuitry.

15. The electronic device of claim 11, wherein the first front end circuitry from among the first front end circuitry, the second front end circuitry, and the third front end circuitry does not include any PA configured to obtain Tx power of a signal.
